# EUROPEAN PATENT SPECIFICATION

(11) **EP 2 201 152 B1**
(45) Date of publication and mention of the grant of the patent: **11.12.2013**
(21) Application number: 08830328.4
(22) Date of filing: 12.09.2008
(51) Int. Cl.: C23C 30/00, B23B 27/14, C23C 14/06, C23C 14/24, C23C 14/32

(54) **COATED CUTTING INSERT FOR MACHINING OF TITANIUM BASED ALLOYS**
BESCHICHTETER SCHNEIDEEINSATZ ZUR BEARBEITUNG VON LEGIERUNGEN AUF TITANBASIS
PIÈCE RAPPORTÉE DE COUPE REVÊTUE POUR L'USINAGE D'ALLIAGES À BASE DE TITANE

(30) Priority: 14.09.2007 SE 0702046
(43) Date of publication of application: 30.06.2010
(73) Proprietor: Seco Tools AB, 737 82 Fagersta (SE)
(72) Inventor: LARSSON, Andreas, S-737 33 Fagersta (SE); LARSSON, Tommy, S-737 90 Ängelsberg (SE)
(74) Representative: Hägglöf, Henrik
(86) International application number: PCT/SE2008/000512
(87) International publication number: WO 2009/035396

(56) References cited:
- EP-A1- 1 722 009
- ZHITOMIRSKY ET AL: "Structure and properties of cathodic vacuum arc deposited NbN and NbN-based multi-component and multi-layer coatings", SURFACE AND COATINGS TECHNOLOGY, ELSEVIER, AMSTERDAM, NL, vol. 201, no. 13, 8 February 2007 (2007-02-08), pages 6122-6130, XP005896578, ISSN: 0257-8972, DOI: 10.1016/J.SURFCOAT.2006.08.125
- ZHITOMIRSKY V N ET AL: "Structure and mechanical properties of vacuum arc-deposited NbN coatings", THIN SOLID FILMS, ELSEVIER-SEQUOIA S.A. LAUSANNE, CH, vol. 326, no. 1-2, 4 August 1998 (1998-08-04), pages 134-142, XP004141473, ISSN: 0040-6090, DOI: 10.1016/S0040-6090(98)00544-6
- ZHITOMIRSKY V N ET AL: "VACUUM ARC DEPOSITION OF TiN, NbN AND TiN/NbN MULTI-LAYER COATINGS", SURFACE AND COATINGS TECHNOLOGY, ELSEVIER, AMSTERDAM, NL, vol. 120-121, 1 January 1999 (1999-01-01), pages 219-225, XP003024926, ISSN: 0257-8972, DOI: 10.1016/S0257-8972(99)00382-5
- ZHITOMIRSKY V.N.: 'Structure and properties of cathodic vacuum arc deposited NbN and NbN-based multi-component and multi-layer coating' SURFACE AND COATINGS TECHNOLOGY vol. 201, no. 13, 26 March 2007, pages 6122 - 6130, XP005896578
- ZHITOMIRSKY V.N. ET AL.: 'Structure and mechanical properties of vacuum arc-deposited NbN coatings' THIN SOLID FILMS vol. 326, 1998, pages 134 - 142, XP004141473
- ZHITOMIRSKY V.N. ET AL.: 'Vacuum arc deposition of TiN,NbN and TiN/NbN multi-layer coatings' SURFACE AND COATINGS TECHNOLOGY vol. 120-121, 1999, pages 219 - 225, XP003024926

## Description

The present invention relates to machining of titanium based alloys such as the alpha, alpha+beta or beta type, for example, Ti6Al4V and Ti5Al5V5Mo3Cr, with coolant. More particularly, the present invention relates to using inserts consisting of a substrate of WC-Co and a hard and wear resistant refractory layer comprisisng NbN resulting in an unexpected increase in tool life and in productivity.

Titanium based alloys are generally divided into three groups often referred to as alpha, alpha+beta and beta alloys. Alloying elements such as Al, V, Sn stabilise the various types of alloys and modify their properties.

Uncoated cemented carbide is normally used for the machining of titanium alloys because uncoated cemented carbides provide wear resistance, toughness and good high temperature properties. So far no improvement has been found when using coated inserts. A cemented carbide with about 6% Co and rest WC with a grain size of 1-2 µm is considered to be the optimum material for machining of titanium alloys. Wet machining is used in order to minimise the generation of heat, thereby increasing the tool life.

EP 1722009 discloses a cutting tool insert, solid end mill, or drill, comprising a substrate and a coating particularly useful in metal cutting applications where the chip thickness is small and the work material is hard e.g. copy milling using solid end mills, insert milling cutters or drilling of hardened steels. The coating is composed of one or more layers of refractory compounds of which at least one layer comprises a h-MelMe2X phase, where Mel is one or several of the elements V, Cr, Nb, and Ta and Me2 is one or several of the elements Ti, Zr, Hf, Al, and Si and X is one or several of the elements N, C, O or B.

EP 1247879 discloses an insert for turning of titanium. By using inserts with a reduced length of primary land compared to prior art an unexpected increase in tool life and productivity has been obtained. Said positive results are further improved by subjecting the inserts to an additional heat treatment after grinding to final shape and dimension.

US 5,325,747 discloses a coated cutting tool having a coating and a substrate. The coating includes at least one CVD layer which may have a residual tensile stress and at least one layer having a high residual compressive stress. The outermost layer of the coating is preferably the one containing residual compressive stresses. The substrate is a composite having hard refractory grains. The cutting tool has been found to be particularly useful in the machining of titanium alloys and superalloys.

US 5,718,541 discloses a cutting tool for machining titanium and titanium alloys which comprises a tungsten carbide-containing substrate alone or with a tungsten carbide tip brazed thereto. The cutting tool further includes a hard coating on either the substrate alone or on the tungsten carbide tip. The coating may be PVD-applied tungsten carbide, CVD-applied boron carbide or PVD-applied boron carbide.

It is an object of the present invention to provide a cutting tool insert for machining of titanium alloys by chip removal with improved properties.

It has been found that inserts provided with an NbN layer display enhanced performance in titanium alloy cutting.

### Brief description of the drawings

Fig 1. X-ray diffraction pattern using CuKα radiation and θ-2θ geometry obtained from an NbN layer, according to the invention, in the as-deposited condition.
Fig 2. X-ray diffraction pattern using CuKα radiation and a constant gracing incident angle of 1° between primary beam and sample surface and by scanning only the detector from an NbN-layer, according to the invention, in as-deposited condition.

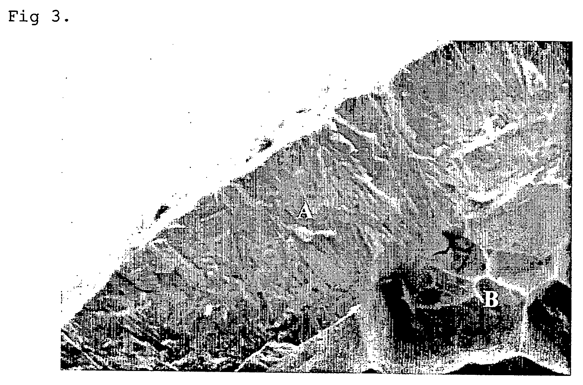

Fig 3. Fracture cross-section of the NbN-layer according to the invention in as-deposited condition. "A" denotes the NbN layer, and "B" denotes the WC-Co substrate.

According to the present invention a coated cutting tool insert is provided with a cemented carbide body having a composition of 4-14 wt% Co, a total content of less than 5% of one or more of the following elements: Ti, Ta, Nb, Cr and V; and that Cr and/or V is present in a total content of 0.1-0.7 wt% and rest WC.

Furthermore, the mean intercept length of the tungsten carbide phase measured on a ground and polished representative cross section is in the range 0.3-0.8 µm, preferably 0.4-0.75 µm. The intercept length is measured by means of image analysis on micrographs with a magnification of 10000x and calculated as the average mean value of about 1000 intercept lengths.

In an embodiment particularly for turning applications, the Co content is 4-8 wt%, preferably 5-7 wt%.

In an embodiment particularly for milling applications, the Co content is 8-14 wt%.

The cemented carbide body is provided with a coating of at least one layer of NbN of a crystalline cubic phase (c-NbN, ICDD PDF 38-1155), as detected by X-ray diffraction (XRD) using CuKα radiation in θ-2θ and/or gracing incidence geometry showing one or more of the following features:
- a c-NbN (111) peak, at about 35 °2θ,
- a c-NbN (200) peak, at about 41 °2θ,
- a c-NbN (220) peak, at about 60 °2θ and
- a c-NbN (311) peak, at about 71 °2θ.

The layer contains an amount of hexagonal NbN (h-NbN, ICDD PDF 25-1361) phase such that the area ratio of (h-NbN(103)+h-NbN(110))/c-NbN(220) is lower than 2.0, as measured by X-ray grazing incidence geometry.

In a preferred embodiment, the coating consists of a single NbN layer.

In another preferred embodiment, the coating consists of a thin, less than 2 µm, TiN layer deposited on the cemented carbide body followed by one layer of NbN.
- The NbN phase(s) may contain elements from the groups IVA-VIA, for example Ti, Zr, Cr, up to 20 at-%, preferably up to 10 at-%, of the metal content.

The total layer thickness, over the cutting edge, of the NbN-layer(s) according to the present invention if combined with other layer(s), is between 0.1 and 10 µm, preferably between 0.5 and 5 µm with the total thickness of the non NbN containing layer(s) less than 10 µm. In case of a single NbN-layer the thickness is 0.5-5 µm.

A method of making a cutting insert by powder metallurgical technique consists of wet milling of powders forming hard constituents and binder phase, compacting the milled mixture to bodies of desired shape and size and sintering, comprising a cemented carbide substrate and a coating. According to the method a substrate according to claim 1 is provided onto which a coating is deposited by arc evaporation composed of one or more layers of refractory compounds of which at least one layer comprises crystalline cubic NbN (c-NbN, ICDD PDF 38-1155) as detected by X-ray diffraction (XRD) in θ-2θ and/or grazing incidence geometry whereby the can NbN-layer contain hexagonal NbN (h-NbN, ICDD PDF 25-1361) phase such that the area ratio of (h-NbN(103)+h-NbN(110))/c-NbN(220) is lower than 2.0, as measured by X-ray grazing incidence geometry and/or elements from groups IVB-VIB, preferably Ti, Zr, Cr, up to 20 at-%, preferably up to 10 at-%, of the metal content. In a preferred embodiment a single NbN-layer is deposited.

The method used to grow the layer, comprising NbN phase of the present invention, is based on arc evaporation of a cathode, under the following conditions:

The evaporation current is between 70 A and 150 A depending on cathode size and cathode material. When using cathodes of 63 mm in diameter the evaporation current is preferably between 80 A and 140 A.

The substrate bias is between -10 V and -80 V, preferably between -20 V and -60 V.

The deposition temperature is between 400°C and 700°C, preferably between 500°C and 700°C.

The atmosphere consists of N₂ at a total pressure of 0.5 Pa to 9 Pa, preferably 1 Pa to 5 Pa.

In order to obtain the preferred structure according to this invention, i.e. a layer containing c-NbN it has been found that several deposition parameters have to be fine-tuned. One important factor is the N₂ partial pressure, P_{N2}. A too low P_{N2} will give h-Nb₂N.

The present invention has been described with reference to layer(s) containing c-NbN phase deposited using arc evaporation. It is obvious that c-NbN phase containing layer(s) also could be produced using other PVD-technologies such as magnetron sputtering, electron beam evaporation, ion plating or laser ablation.

The present invention also relates to the use of inserts according to above for wet machining of titanium based alloys, such as Ti6Al4V and Ti5Al5V5Mo3Cr, when turning at a cutting speed of 20-120 m/min, a cutting depth 0.5-8 mm and a feed of 0.05-1.0 mm/rev, and when milling at a cutting speed of 20-120 m/min, and a feed of 0.05-0.5 mm/tooth.

### Example 1 (Grades A-D and G not falling within the scope of the invention)

Grade A: A cemented carbide substrate, with the average composition 6.0 wt% Co, and balance WC, and a mean intercept length of WC in the sintered body of 0.64 was produced by conventional milling of powders, pressing of green compacts and subsequent sintering at 1430°C. The substrate was coated, as described below, with a 1.9 µm thick layer of NbN.

Grade B: A cemented carbide cutting tool, with the average composition 6.0 wt% Co, and balance WC, and a mean intercept length of WC in the sintered body of 0.64 was produced by conventional milling of powders, pressing of green compacts and subsequent sintering at 1430°C.

Grade C: A cemented carbide cutting tool, with the average composition 6.0 wt% Co, and balance WC, and a mean intercept length of WC in the sintered body of 0.64 was coated with a 2.1 µm thick layer of Ti_{0.33}Al_{0.67}N.

Grade D: A cemented carbide substrate according to the invention, with the composition 12 wt% Co, 1.2 wt% Ta, 0.2 wt% Nb and balance WC, was produced by conventional milling of powders, pressing of green compacts and subsequent sintering at 1430°C. Investigation of the microstructure after sintering showed that the mean intercept length of the tungsten carbide phase was 0.59 µm. The substrate was coated, as described below, with a 1.1 µm thick layer of NbN.

Grade E: A cemented carbide substrate with composition 13 wt% Co, 0.52 wt% Cr and balance WC, and a mean intercept length of WC in the sintered body of 0.48 µm, was coated according to Grade D, in accordance with the invention.

Grade F: A cemented carbide substrate with average composition 10 wt% Co, 0.41 wt% Cr and balance WC, and a mean intercept length of WC in the sintered body of 0.48 µm, was coated according to Grade D, in accordance with the invention.

Grade G: A cemented carbide substrate according to the invention, with the composition 12 wt% Co, 1.2 wt% Ta, 0.2 wt% Nb and balance WC, was produced by conventional milling of powders, pressing of green compacts and subsequent sintering at 1430°C. Investigation of the microstructure after sintering showed that the mean intercept length of the tungsten carbide phase was 0.59 µm. The substrate was coated with a 1.3 µm thick layer of Ti_{0.33}Al_{0.67}N.

Before deposition, the substrates were cleaned in ultrasonic baths using alkali solution and alcohol and subsequently placed in the PVD-system using a fixture of three-fold rotation. The shortest cathode-to-substrate distance was 130 mm. The system was evacuated to a pressure of less than 2.0×10⁻³ Pa, after which the substrates were sputter cleaned with Ar ions. The layers were grown using arc evaporation of Nb cathodes (63 mm in diameter). The deposition was carried out in a 99.995% pure N₂ atmosphere at a total pressure of 3.0 Pa, using a substrate bias of -25 V for 20 minutes. The layer thickness was about 1 µm over the cutting edge. The deposition temperature was about 530°C.

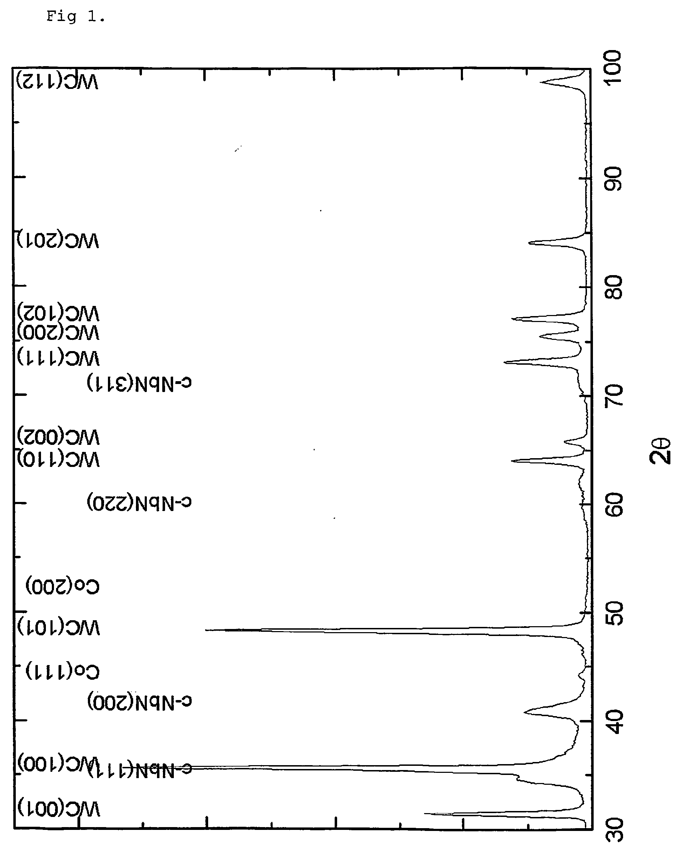

The X-ray diffraction pattern (CuKα radiation, θ-2θ geometry) of the as-deposited c-NbN (ICDD PDF 38-1155) layer is shown in Figure 1.

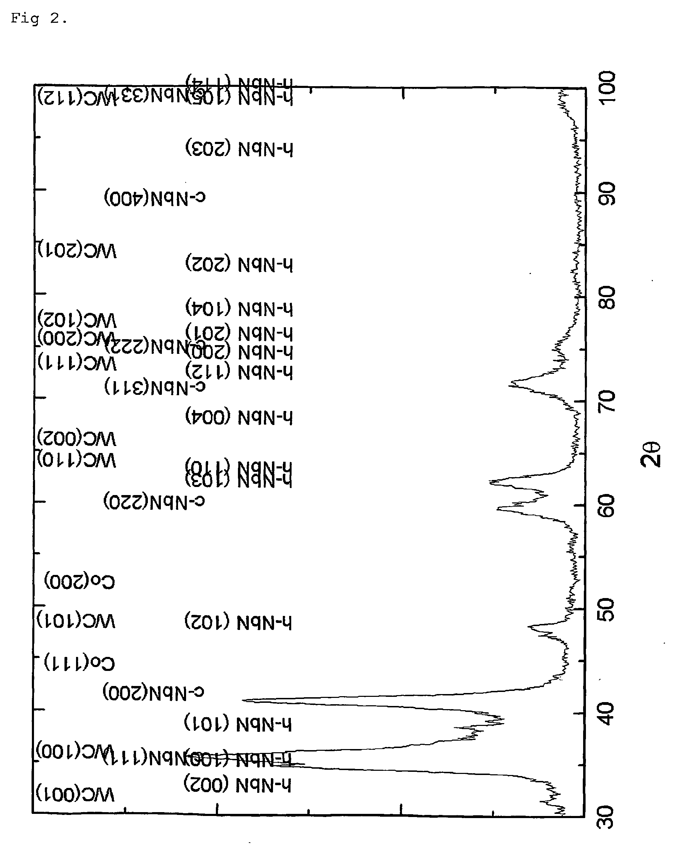

Phase identification of the NbN in as-deposited condition was made by X-ray diffraction using a constant gracing incident angle of 1° between primary beam and sample surface and scanning the detector in order to magnify peaks originating from the layer, see Figure 2. The presence of h-NbN is confirmed by the indexing of the diffraction pattern (ICDD PDF 25-1361). The area ratio of (h-NbN(103)+h-NbN(110))/c-NbN(220) is 1.1.

Ti_{0.33}Al_{0.67}N layers were deposited using conventional arc technology.

### Example 2

Grades A, B and C were tested in a turning operation of titanium (Ti6Al4V) rings with interruptions.

| Material: | Titanium Ti6Al4V |
|---|---|
| Component | Ring |
| Insert type: | SNMG150612-MR4 |
| Cutting speed: | 45 m/min |
| Feed: | 0.4 mm/rev. |
| Depth of cut: | 2.0 mm |
| Coolant: | Yes |
| Remarks: | Interrupted machining |

| Results: | Number of produced pieces |
|---|---|
| Grade A | 3 |
| Grade B | 2 |
| Grade C | 2 |

The test was stopped when the flank wear reached a maximum value of 0.4 mm.

### Example 3

Grades D, E, F and G were tested in square shoulder milling of a structural titanium component.

| Material: | Titanium Ti6Al4V |
|---|---|
| Component | Structural component |
| Insert type: | XOEX120408R-M07 |
| Cutting speed: | 65 m/min |
| Feed: | 0.15 mm/tooth |
| Depth of cut: | 3-4 mm |
| Width of cut: | 20 mm |
| Coolant: | Yes |

| Results: | Tool life (min) |
|---|---|
| Grade D | 26 |
| Grade E | 28 |
| Grade F | 32 |
| Grade G | 20 |

The test was stopped when the flank wear reached a maximum value of 0.25 mm.

### Example 4

Grades D, E, F and G were tested in rough face milling of a titanium bar.

| Material: | Titanium Ti6Al4V |
|---|---|
| Component | Bar |
| Insert type: | SEEX1204AFN-M10 |
| Cutting speed: | 45 m/min |
| Feed: | 0.2 mm/tooth |
| Depth of cut: | 3.0 mm |
| Width of cut: | 20 mm |
| Coolant: | Yes |
| Remarks: | Good stability |

| Results: | Tool life (min) |
|---|---|
| Grade D | 15 |
| Grade E | 12 |
| Grade F | 9 |
| Grade G | 11 |

The test was stopped when the flank wear reached a maximum value of 0.4 mm.

### Example 5

Grades D and G were tested in rough face milling of a titanium component.

| Material: | Titanium Ti5Al5V5Mo3Cr |
|---|---|
| Component | Bar |
| Insert type: | SEEX1505AFN-M12 |
| Cutting speed: | 22 m/min |
| Feed: | 0.18 mm/tooth |
| Depth of cut: | 5 mm |
| Width of cut: | 95 mm |
| Coolant: | Yes |

| Results: | Tool life (min) |
|---|---|
| Grade D | 90 |
| Grade G | 10 |

The test was stopped when the flank wear reached a maximum value of 0.4 mm.

## Claims

1. Cutting tool insert, particularly useful for machining of titanium alloys, comprising a cemented carbide substrate and a coating, **characterised in**
- the cemented carbide having a composition of 4-14 wt% Co; a total content of less than 5 wt % of one or more of the following elements: Ti, Ta, Nb, Cr and V; and that Cr and/or V is present in a total content of 0.1-0.7 wt%; and rest WC; with a mean intercept length of the tungsten carbide in the range 0.3-0.8 µm, preferably 0.4-0.75 µm, and
- the coating being composed of one or more layers of refractory compounds of which at least one layer comprises crystalline cubic NbN (c-NbN, ICDD PDF 38-1155) as detected by X-ray diffraction (XRD) in θ-2θ and/or grazing incidence geometry, whereby the at least one NbN-layer contains hexagonal NbN (h-NbN, ICDD PDF 25-1361) phase such that the area ratio of (h-NbN(103)+h-NbN(110))/c-NbN(220) is lower than 2.0, as measured by X-ray grazing incidence geometry, and/or elements from groups IVA-VIA, preferably Ti, Zr, Cr, up to 20 at-%, preferably up to 10 at-%, of the metal content, and that the at least one NbN-layer has a total thickness, over the cutting edge, of between 0.1 and 10 µm, preferably between 0.5 and 5 µm, with a total thickness of the non NbN containing layer(s) of less than 10 µm.

2. Cutting tool insert according to claim 1, wherein the at least one layer consists of cubic NbN only, as determined by X-ray diffraction (XRD) in θ-2θ geometry.

3. Cutting tool insert according to claim 1, wherein the at least one layer consists of pure NbN.

4. Cutting tool insert according to any of the preceding claims, wherein a TiN layer is arranged between the cemented carbide substrate and the at least one NbN-layer.

5. Cutting tool insert according to any of the preceding claims, wherein the TiN layer is less than 2 µm thick.

6. Use of inserts according to any of claims 1-5 for wet machining of titanium based alloys, such as Ti6Al4V and Ti5Al5V5Mo3Cr,
- when turning at a cutting speed of 20-120 m/min, a cutting depth 0.5-8 mm and a feed of 0.05-1.0 mm/rev., and
- when milling at a cutting speed of 20-120 m/min, and a feed of 0.05-0.5 mm/tooth.

## Patentansprüche

1. Einsatz für ein Schneidwerkzeug, welcher insbesondere für ein Bearbeiten von Titanlegierungen verwendbar ist und welcher ein Sintercarbidsubstrat sowie eine Beschichtung aufweist, **dadurch gekennzeichnet, dass**
- das Sintercarbid eine Zusammensetzung aus 4-14 Gew.-% Co, einen Gesamtanteil von weniger als 5 Gew.-% von einem oder mehreren der folgenden Elemente hat: Ti, Ta, Nb, Cr und V, und dass Cr und/oder V in einem Gesamtanteil von 0,1-0,7 Gew.-% vorhanden sind und der Rest aus WC besteht, mit einer mittleren Abfang- bzw. Sehnenlänge des Wolframcarbids im Bereich von 0,3-0,8 µm, vorzugsweise 0,4-0,75 µm, und
- die Beschichtung aus einer oder mehreren Schichten von feuerfesten Verbindungen besteht, von denen zumindest eine Schicht kristallines, kubisches NbN (c-NbN, ICDD PDF 38-1155) aufweist, wie es mittels Röntgenbeugung (XRD) in einer θ-2θ-Geometrie und/oder einer Geometrie mit einem streifendem Einfall erfasst wird, wobei die zumindest eine NbN-Schicht hexagonales NbN (h-NbN, ICDD PDF 25-1361) beinhaltet, sodass das Flächenverhältnis (h-NbN(103)+h-NbN(110))/c-NbN(220) kleiner als 2,0 ist, wie es mittels einer Geometrie mit einem streifendem Einfall von Röntgenstrahlen gemessen wird, und/oder Elemente aus den Gruppen IVA-VIA, vorzugsweise Ti, Zr, Cr, mit bis zu 20 At.-%, vorzugsweise mit bis zu 10 At.-% des metallischen Anteils, und dass die zumindest eine NbN-Schicht eine Gesamtdicke über der Schneidkante zwischen 0,1 und 10 µm, vorzugsweise zwischen 0,5 und 5 µm besitzt, mit einer Gesamtdicke der NbN-freien Schicht(en) von weniger als 10 µm.

2. Einsatz für ein Schneidwerkzeug nach Anspruch 1, wobei die zumindest eine Schicht ausschließlich aus kubischem NbN besteht, wie es mittels Röntgenbeugung (XRD) in einer θ-2θ-Geometrie bestimmt wird.

3. Einsatz für ein Schneidwerkzeug nach Anspruch 1, wobei die zumindest eine Schicht aus reinem NbN besteht.

4. Einsatz für ein Schneidwerkzeug nach einem der vorangehenden Ansprüche, wobei eine TiN-Schicht zwischen dem Sintercarbidsubstrat und der zumindest einen NbN-Schicht angeordnet ist.

5. Einsatz für ein Schneidwerkzeug nach einem der vorangehenden Ansprüche, wobei die TiN-Schicht weniger als 2 µm dick ist.

6. Verwendung von Einsätzen nach einem der Ansprüche 1 bis 5 zum Nassbearbeiten von Legierungen auf Titanbasis, wie zum Beispiel Ti6Al4V und Ti5Al5V5Mo3Cr,
- mit einer Schnittgeschwindigkeit von 20-120 m/min, einer Schnitttiefe von 0,5-8 mm und einem Vorschub von 0,05-1,0 mm/U beim Drehen, und
- mit einer Schnittgeschwindigkeit von 20-120 m/min und einem Vorschub von 0,05-0,5 mm/Zahn beim Fräsen.

## Revendications

1. Pièce rapportée d'outil de coupe, particulièrement utile pour usiner des alliages de titane, comprenant un substrat de carbure cémenté et un revêtement, **caractérisé en ce que**
- le carbure cémenté a une composition de 4 à 14 % en poids de Co, une teneur totale inférieure à 5 % en poids de l'un ou plusieurs des éléments suivants : Ti, Ta, Nb, Cr et V, et **en ce que** le Cr et/ou V est présent suivant une teneur totale de 0,1 à 0,7 % en poids, et le reste étant du WC, avec une longueur d'interception moyenne du carbure tungstène dans la plage de 0,3 à 0,8 µm, de préférence de 0,4 à 0,75, et
- le revêtement est composé d'une ou plusieurs couches de composés réfractaires dont au moins une couche comprenant un cristal cubique (c-NbN, ICDD PDF 38-1155) détecté par diffraction aux rayons X (XRD) dans une géométrie d'incidence θ-2θ et/ou de brillance, grâce à quoi la au moins une couche NbN contient une phase hexagonale (h-NbN, ICCD PDF 25-1361) telle que le rapport de surface (h-NbN(103)+h-NbN(110))/c-NbN(220) soit inférieur à 2,0, mesuré par géométrie d'incidence de brillance aux rayons X, et/ou des éléments des groupes IVA/VIA, de préférence Ti, Zr, Cr, jusqu'à 20 % atomiques, de préférence jusqu'à 10 % atomiques de la teneur en métal, et **en ce que** la au moins une couche de NbN a une épaisseur totale, sur l'arête de coupe, entre 0,1 et 10 µm, de préférence entre 0,5 et 5 µm, avec une épaisseur totale de la ou des couches ne contenant pas de NbN inférieure à 10 µm.

2. Pièce rapportée d'outil de coupe selon la revendication 1, dans laquelle la au moins une couche est constituée de cristal cubique NbN seulement, comme déterminé par diffraction aux rayons X (XRD) en géométrie θ-2θ.

3. Pièce rapportée d'outil de coupe selon la revendication 1, dans laquelle la au moins une couche est constituée de NbN pur.

4. Pièce rapportée d'outil de coupe selon l'une quelconque des revendications précédentes, dans laquelle une couche de TiN est disposée entre le substrat de carbure cémenté et la au moins une couche NbN.

5. Pièce rapportée d'outil de coupe selon l'une quelconque des revendications précédentes, dans laquelle la couche de TiN est d'une épaisseur inférieure à 2 µm.

6. Utilisation de pièces rapportées selon l'une quelconque des revendications 1 à 5 pour un usinage humide d'alliages à base de titane, tels que le Ti6Al4V et le Ti5Al5V5Mo3Cr,
- lors d'une rotation à une vitesse de coupe de 20 à 120 m/min, une profondeur de coupe de 0,5 à 8 mm et une avance de 0,05 à 1,0 mm/tour, et
- lors d'un meulage à une vitesse de coupe de 20 à 120 m/min, et une avance de 0,05 à 0,5 m/dent.
